# EUROPEAN PATENT APPLICATION

(11) **EP 0 855 739 A1**
(43) Date of publication of application: **29.07.1998**
(21) Application number: 98300488.8
(22) Date of filing: 23.01.1998
(51) Int. Cl.: H01L 21/762

(54) **Tapered dielectric etch process for moat etchback**

(30) Priority: 24.01.1997 US 36725 P
(71) Applicant: TEXAS INSTRUMENTS INC., Dallas, Texas 75243 (US)
(72) Inventor: Brankner, Keith J., Richardson, Texas 75080 (US); Shinn, Gregory B., Dallas, Texas 75244 (US)
(74) Representative: Potter, Julian Mark

(57) **Abstract**

A tapered dielectric etch process that may be used for moat etchback in STI. After isolation trenches (14) are etched and filled, the invention may be used in the process to planarize the structure. First, a pattern (40), such as a reverse moat pattern is applied to the structure over the trench-fill material (16). The trench fill material (16) is then etched using the pattern (40). An isotropic etch is performed that removes the pattern (40) in the dense areas only. The isotropic etch may be combined with anisotropic etches performed prior to and/or after the isotropic etch to remove additional trench fill material (16). Thus, a significant amount of the excess trench-fill material (18) is removed prior to CMP. CMP may then be performed.

## Description

This invention generally relates to semiconductor processing and more specifically, but not exclusively, to dielectric etch processes for use in conjunction with a planarization process.

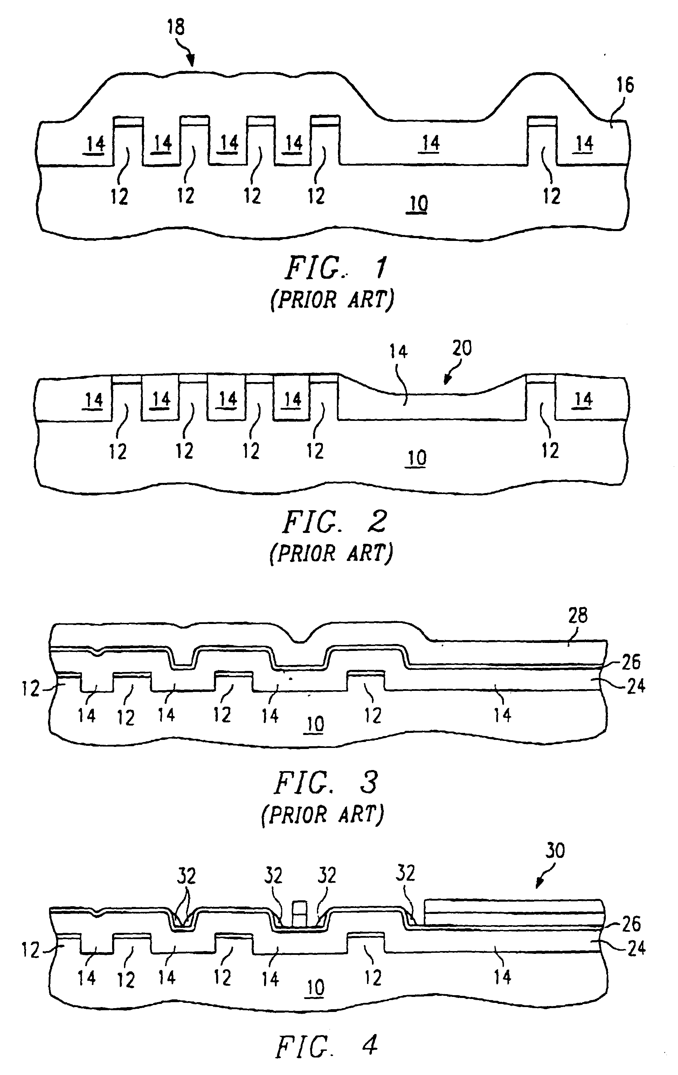

Shallow trench isolation (STI) is a leading candidate for providing isolation between devices on integrated circuits (ICs) . Device dimensions have shrunk to the submicron range and are still shrinking. Isolation structures between these devices need to shrink correspondingly. Companies are looking at STI to fill this isolation requirement. Referring to FIG. 1, STI involves etching trenches 14 of equal depth and varying width into the semiconductor layer 10 between active areas 12 (i.e., areas where active devices will subsequently be formed). Usually, a nitride layer N is used as a hardmask for the trench etch and as a CMP etchstop. The trenches 14 are then typically filled with a dielectric material 16, such as silicon dioxide. During this trench fill process, a significant amount of dielectric material 18 extends above active areas 12 of the device. This is shown in FIG. 1. This excess dielectric material 18 is then typically removed using a chemical-mechanical polish (CMP) planarization step, stopping on the nitride layer N over active areas 12 and leaving dielectric material 16 in the trenches 14.

There are several concerns that occur in removing the excess dielectric material 18. Due to the nature of the CMP process, the removal rate of the excess dielectric material 18 is dependent on the feature size and the local pattern density. This variation in removal rate can result in damage to the silicon under isolated moat features or incomplete removal of the oxide over large/dense moat features. (Note: moat is the area under the nitride stop layer in FIG. 1.) The pattern density effect and the polish nonuniformity result in nonuniform field oxide thickness within the product. Several techniques have been used to minimize the field oxide nonuniformity, such as use of a nitride overlayer to prevent dishing in wide field regions or use of a patterned etchback prior to CMP to reduce the amount of material to be removed.

One prior art method uses an etchstop layer 26 between two conformal dielectric layers 24, 28, as shown in FIG. 3. A two layer resist mask 30 is then formed covering depressions of sufficient width. Mask 30 is a reverse tone of the active area mask that is undersized or reduced such that the mask does not sit on the sidewalls of the depression areas and is only located in depressions of sufficient width. The upper conformal oxide layer 28 is then etched, using mask 30, and etchstop layer 26 as an etchstop. The etch leaves some of the dielectric material 32 on the sidewalls of the depression areas, as shown in FIG. 4. The resist mask 30 is then stripped and CMP is performed to planarize the structure. Because the wider depression areas are filled, planarization uniformity is improved. However, this approach has added complexity with the extra deposition of an etchstop layer and second conformal dielectric layer and further reductions in CMP time are desired.

The preferred embodiment of the invention is a tapered dielectric etch process that may be used prior to CMP for STI applications. After isolation trenches are etched and filled, the invention may be used in the process to reduce the amount of material to be polished and to partially planarize the structure. First, a pattern, such as a reverse moat pattern, is applied to the structure over the trench-fill material. The trench fill material is then etched using the pattern. The etch chemistry and conditions can be adjusted to etch both the trench fill material and the masking material, thus resulting in a more isotropic etch that can remove the excess fill material above the trench etch hardmask, but leaving all or most of the trench fill material in the trenches. Thus, a significant amount of the excess trench-fill material is removed prior to CMP. CMP may then be performed.

An advantage of the preferred embodiment of the invention is providing STI having increased uniformity.

A further advantage of the preferred embodiment of the invention is providing a STI process that required less CMP time.

These and other advantages will be apparent to those of ordinary skill in the art having reference to the specification in conjunction with the drawings.

The present invention will now be further described by way of example, with reference to the accompanying drawings in which:
FIG. 1 is a cross-sectional diagram of a prior art trench-fill process indicating excess material over the denser areas of the IC;
FIG. 2 is a cross-sectional diagram of a prior art trench-fill process after planarization illustrating the problem of "dishing";
FIG. 3 is a cross-sectional diagram of another prior art trench-fill process using an etchstop layer and a reduced reverse moat pattern before etching;
FIG. 4 is a cross-sectional diagram of another prior art trench-fill process using an etchstop layer and a reduced reverse moat pattern after etching;
FIGs. 5-8 are cross-sectional diagrams of semiconductor structure at various stages of a trench-fill process;
FIGs. 9A&B are cross-sectional diagrams of a dense portion of a semiconductor structure after an anisotropic only and a combined anisotropic/isotropic etch, respectively;
FIGs. 10A&B are cross-sectional diagrams of an isolated portion of a semiconductor structure after an anisotropic only and a combined anisotropic/isotropic etch, respectively; and
FIGs. 11A&B are top view diagrams of a semiconductor structure after an anisotropic only and a combined anisotropic/isotropic etch, respectively.

Corresponding numerals and symbols in the different figures refer to corresponding parts unless otherwise indicated.

An embodiment of the invention will now be described in conjunction with shallow trench isolation (STI), and specifically a moat etchback/CMP process for STI. However, it will be apparent to those of ordinary skill in the art that the invention is applicable in general when CMP planarization is desired and "dishing" of a lower surface could be a problem.

As device geometries shrink further into the submicron region, STI is the isolation technique being used to isolate electrically active devices of a IC from one another. ICs typically have a dense area, wherein devices of minimum device width and isolation spacing are placed, and isolated areas where larger devices and/or large isolation spacings are found. For STI formation, shallow trenches of uniform depth (e.g., 4500A) are etched into a semiconductor body where isolation is desired. The trenches are then filled, typically with a dielectric material such as silicon dioxide. The deposition of the trench-fill material 16 results in topography difference between the dense 18 and isolated areas, as shown in FIG 1. Accordingly, after the deposition of the trench-fill material 16, the structure needs to be planarized. It is the planarization process sequence of the STI formation to which the invention is specifically applied.

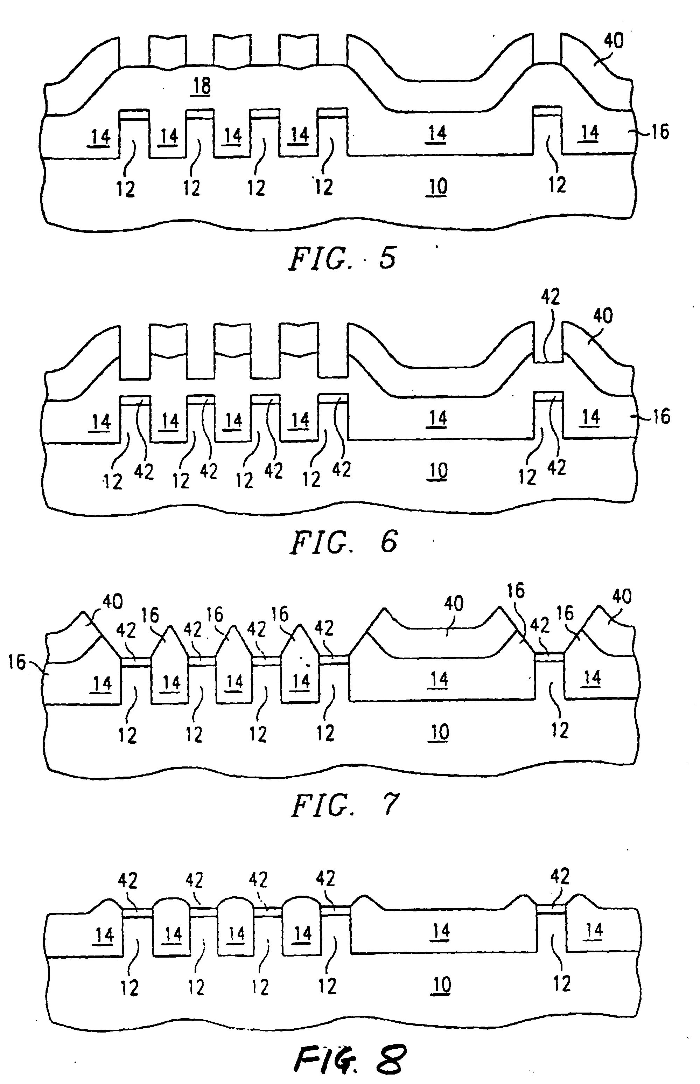

A method for planarizing the structure of FIG. 1 according to the invention will now be described with reference to FIGs. 5-8. Referring to FIG. 5, a pattern 40, such as a reverse moat pattern, is formed on the surface of the structure. The function of the pattern is to protect all "low" areas 14 so that material may be removed from the "high" areas 18. It is important that the corners of the trench are also protected and that the trench fill material 16 is not subsequently etched through at the corners. A reverse moat pattern 40 is shown in FIG. 5. The reverse moat pattern 40 comprises an etch resistant material such as resist. A reverse moat pattern is simply the reverse of the pattern that was used to etch the trenches 14 (i.e., the regions of the structure that were exposed by the pattern for the trench etch are now covered and the regions of the structure that were covered by the pattern for the trench etch are now exposed).

Using reverse moat pattern 40, the structure may be etched. FIGs. 6-8 show the results of a three step etch. It should be noted that the etch process may be optimized to only require a two step etch or a one step isotropic etch. Two optimized two-step etches are described hereinbelow. The results of a first anisotropic etch are shown in FIG. 6. An isotropic etch could alternatively be performed at this point. Where exposed by reverse moat pattern 40, trench-fill material 16 is partially removed. Suitable etch chemistries and etch processes will be apparent to those of ordinary skill in the art having reference to this specification and will depend on the type of material used for trench-fill material 16. An exemplary etch process for the first anisotropic etch is shown in Table I under STEP 1.

**Table I**

| | STEP 1 | STEP 2 | STEP 3 |
|---|---|---|---|
| Target material | oxide | resist | oxide |
| Tool vendor= | AMAT | Lam | AMAT |
| mainframe | 5000 | 4526 | 5000 |
| chamber | mark 2 | oxide | mark 2 |
| # gases | 3 | 4 | 3 |
| Ar | 75 | 100 | 75 |
| CF₄ | 6 | 25 | 6 |
| CHF₃ | 25 | 5 | 25 |
| O₂ | | 40 | |
| backside pressure | 8 | 10 | 8 |
| chamber pressure, mT | 50 | 600 | 50 |
| RF source, W | 650 | 650 | 650 |
| Wall or Top Temp. C | 40 | 50 | 40 |
| Wafer Chuck Temp C | 20 | -15 | 20 |
| gap, cm | | 1.2 | |
| loFAT RF tap | | 6 | |
| EPD line or timed | 20s | 30s | ∼87 s |
| EPD wavelength | | | 3871 A |

The first anisotropic etch is a timed etch with the timing chosen to remove a given depth of material 16. In the example of Table I, the duration of the etch is on the order of 20 seconds. The etch chemistry shown consists of Ar, CF₄, and CHF₃. Preferably, material 16 is not removed completely down to nitride 42. Enough fill material 16 should remain over the nitride to avoid etching into the trench areas 14 during the subsequent isotropic etch.

Next, an isotropic etch is performed on trench-fill material 16. The result is shown in FIG. 7. Here, a significant portion of the excess material 18 of trench-fill material 16 is removed prior to CMP. There is less trench-fill material over the dense areas that needs to be removed via CMP. Thus, the CMP planarization can be accomplished in less polish time and with more uniformity. One exemplary etch process is shown above in Table I under STEP 2. The isotropic etch described in Table I, STEP 2, is a timed etch on the order of 30 seconds in duration and uses an etch chemistry consisting of Ar, CF₄, CHF₃, and O₂. Other suitable etches will be apparent to those of ordinary skill in the art. The isotropic etch is preferably a timed etch designed to stop when all the excess material 18 is removed or when as much of excess material 18 is removed as can be without removing all the resist over the isolated areas and etching into the larger trenches 14.

Finally, a second anisotropic etch may be performed if all of the excess material 18 has not been previously removed. Preferably, this step is not required. Additional trench-fill material 16 is removed until the nitride layer 42 over active areas 12 is exposed, as shown in FIG. 8. An exemplary etch recipe is shown in Table I under STEP 3. The second anisotropic etch shown in Table I has a duration on the order of 87 seconds and uses the same etch chemistry as the first anisotropic etch. Other suitable etches will be apparent to those of ordinary skill in the art. In fact, in may be beneficial to design the three etches (the first anisotropic etch, the isotropic etch, and the second anisotropic etch) so that they may be performed in a cluster tool or even in the same chamber. After the second anisotropic etch is performed, any remaining resist is removed and CMP may be performed to planarize the structure. Suitable CMP processes will be apparent to those of ordinary skill in the art.

Table II illustrates an optimized two step etch for 200 mm diameter wafers. A two step etch is preferable over a three step etch such as that described above for reducing process complexity.

**Table II.**

| Step Description | units | Anisotro pic | Isotropi c |
|---|---|---|---|
| Lam tool model | | 4528 | 4528 |
| Top electrode temp | °C | 40 | 40 |
| Bottom electrode T | °C | 10 | 10 |
| Pressure | mT | 150 | 750 |
| Rf top | watts | 506 | 506 |
| loFAT RF tap | integ er | 6 | 6 |
| GAP | cm | 1 | 1 |
| Ar | sccm | 500 | 40 |
| CF4 | sccm | 50 | 10 |
| CHF3 | sccm | | 5 |
| O2 | sccm | | 20 |
| Backside He clamp | Torr | 4 | 4 |
| Completion | | timed | endpoint |
| Endpoint parameters: | | | |
| wavelength | nm | | 387 |
| delay | sec | | 20 |
| norm | sec | | 5 |
| norm value | integ er | | 0 |
| trigger | % | | 140 |
| slope | cs/c | | 0 |
| slope | sec | | 0 |
| | | | |
| oxide V.ER | Ang/s ec | 53 | 56 |
| resist V.ER | Ang/s ec | 45 | 102 |
| resist H.ER | Ang/s ec | 20 | 96 |
| Selectivity TEOS/PR | V/V | 1.2 | 0.5 |
| ER ratio PR/PR | H/V | 0.4 | 0.9 |

The first etch is an anisotropic etch that performs the same function as the first anisotropic etch described above. The second etch is isotropic. The etches are optimized so that the more of the excess material 18 is removed than in the prior embodiment and a third anisotropic etch is not necessary.

Table III illustrates a similar two-step etch optimized for a wafer diameter of 150mm.

**Table III.**

| Step Description | units | Anisotropic | Isotropic |
|---|---|---|---|
| Lam tool model | | 4526 | 4526 |
| Top electrode temp | °C | 50 | 50 |
| Bottom electrode T | °C | -15 | -15 |
| Pressure | mT | 600 | 600 |
| Rf top | watts | 650 | 650 |
| loFAT RF tap | integer | 6 | 6 |
| GAP | cm | 1.2 | 1.2 |
| Ar | sccm | 100 | 100 |
| CF4 | sccm | 60 | 25 |
| CHF3 | sccm | 10 | 5 |
| O2 | sccm | | 40 |
| Backside He clamp | Torr | 10 | 10 |
| Completion | | timed | endpoint |
| Endpoint parameters: | | | |
| wavelength | nm | | 387 |
| delay | sec | | 20 |
| norm | sec | | 5 |
| norm value | integer | | 0 |
| trigger | % | | 140 |
| slope | cs/c | | 0 |
| slope | sec | | 0 |
| | | | |
| oxide V.ER | Ang/sec | 119 | 104 |
| resist V.ER | Ang/sec | 51 | 49 |
| resist H.ER | Ang/sec | 13 | 102 |
| Selectivity TEOS/PR | V/V | 2.3 | 2.1 |
| ER ratio PR/PR | H/V | 0.3 | 2.1 |

The above tables describe specific process chemistries and conditions. They are intended as examples only. Other etch chemistries and process conditions will be apparent to those skilled in the art. Examples include other oxide plasma etch chemistries (e.g. C2F6 and O2 with or without other inert gas additions) and other tools such as inductively coupled plasma tools. The key in the above examples is increasing the O2 to increase the horizonal etch rate in the isotropic etch step.

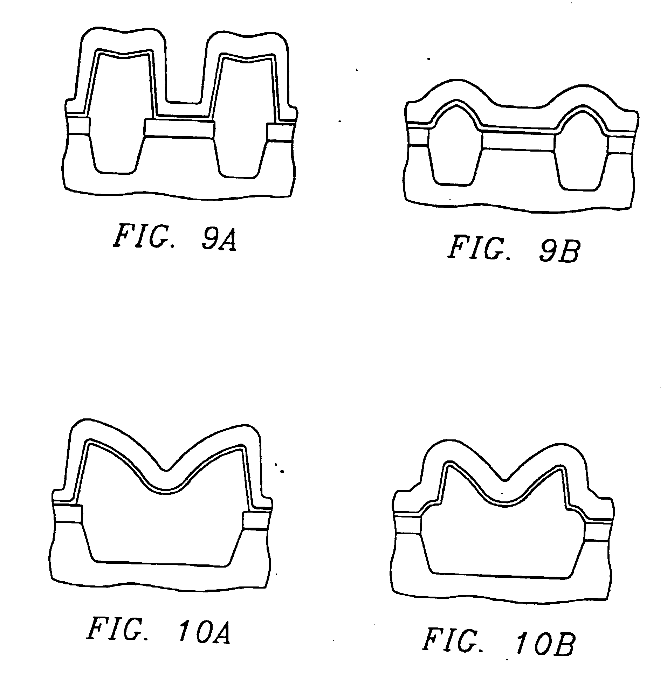

FIG. 9A is a cross-sectional diagram of dense area of an IC after using a reverse moat pattern and an anisotropic etch only. FIG. 9B, in contrast, in a cross-sectional diagram of a dense area of an IC using an embodiment of the invention including both the anisotropic and isotropic etchbacks. Both diagrams are of a device prior to CMP planarization. As can be noted from FIGS. 9A&B, the addition of the isotropic etchback removes a significantly larger amount of trench-fill material 16 over trenches 14. FIGs. 10A&B are cross-sectional diagrams of an isolated area of an IC having anisotropic only and a combined anisotropic/isotropic etchback, respectively.

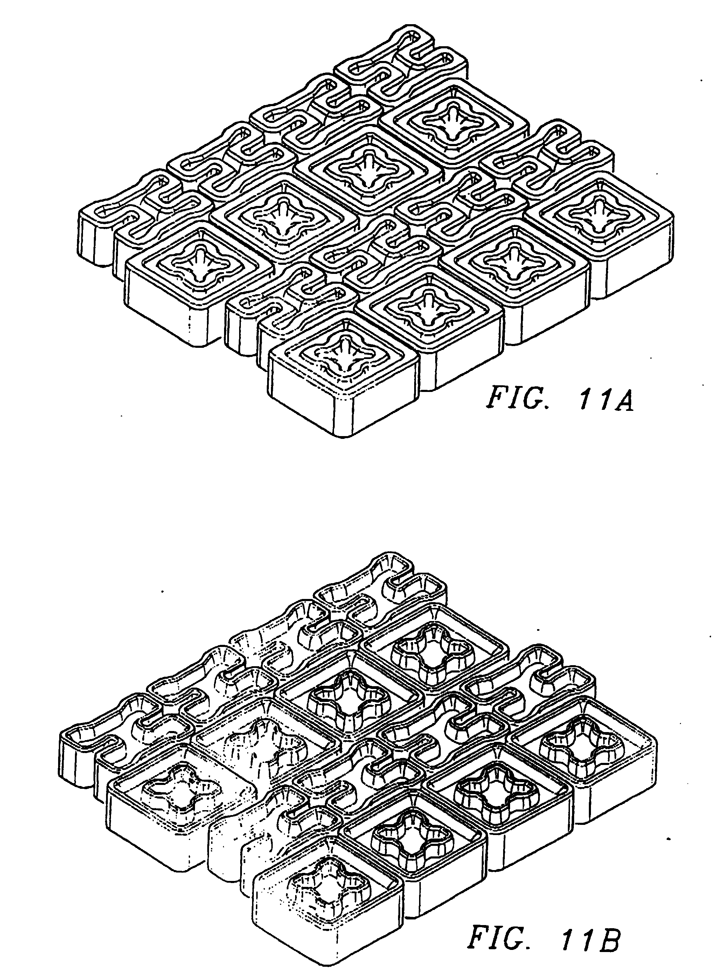

FIG. 11A is a top view of both dense and isolated areas of an IC of a reverse moat pattern and an anisotropic etch, only. FIG. 11B, in contrast, in a top view of both dense and isolated areas of an IC using an embodiment of the invention including both the anisotropic and isotropic etchbacks. Both diagrams are of a device prior to CMP planarization. Clearly, FIG. 11B shows less material to be removed during CMP planarization. Accordingly, less polish time will be required.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

The scope of the present disclosure includes any novel feature or combination of features disclosed therein either explicitly or implicitly or any generalisation thereof irrespective of whether or not it relates to the claimed invention or mitigates any or all of the problems addressed by the present invention. The applicant hereby gives notice that new claims may be formulated to such features during the prosecution of this application or of any such further application derived therefrom. In particular, with reference to the appended claims, features from dependent claims may be combined with those of the independent claims in any appropriate manner and not merely in specific combinations enumerated in the claims.

## Claims

1. A method of planarizing a structure having both dense and isolated areas after the deposition of a fill material, comprising the steps of:
forming a pattern over said fill material, said pattern covering said isolated areas and selected portions of said dense areas; and
isotropically etching said pattern and said fill material.

2. The method of Claim 1, further comprising the step of anisotropically etching said fill material after said step of isotropically etching said fill material.

3. The method of Claim 2, wherein the anisotropic etching step removes all of said fill material over the portions of said dense area previously exposed by said pattern.

4. The method of any preceeding claim, further comprising the step of chemically-mechanically polishing said structure after the isotropically etching step.

5. The method of any preceeding claim, wherein said pattern comprises resist.

6. The method of any of Claims 1 to 4, wherein said pattern comprises a reverse moat pattern.

7. The method of Claim 1, further comprising the step of anisotropically etching said fill material prior to said isotropically etching step.

8. The method of Claim 7, wherein the anisotropically etching step does not completely remove the fill material exposed by said pattern.

9. The method of any preceeding claim, wherein said isotropically etching step removes all of said fill material over the portions of said dense area previously exposed by said pattern.

10. The method of any preceeding claim, wherein said isotropically etching step continues until said pattern is removed in said dense areas but not in said isolated areas.

11. A method of forming isolation trenches comprising the steps of:
etching a plurality of trenches in a semiconductor body, said trenches forming a dense area having narrowly spaced trenches and an isolated area having wide trenches;
depositing a trench-fill material over said semiconductor body, said trench-fill material overfilling said trenches in said dense area;
forming a reverse moat mask over said trench-fill material;
isotropically etching said reverse moat pattern and said trench-fill material to remove said pattern over said dense area but not over said isolated area; and
chemically-mechanically polishing said trench fill material.

12. The method of Claim 11, wherein said semiconductor body contains active areas having a nitride layer formed thereover and wherein the isotropic etching step removes said trench-fill material until said nitride layer is exposed.

13. The method of Claim 11, further comprising the step of first etching said trench-fill material prior to said isotropically etching step.

14. The method of Claim 13, wherein said first etching step comprises an anisotropic etch.

15. The method of Claim 13, wherein the first etching step of said trench-fill material comprises an isotropic etch.

16. The method of Claim 11, further comprising the step of anisotropically etching said trench fill material after said isotropically etching step.
